Europäisches Patentamt

European Patent Office

Office européen des brevets

(11) Publication number: 0 116 702

A2

# (12) EUROPEAN PATENT APPLICATION

(21) Application number: 83112056.3

(22) Date of filing: 01.12.83

(51) Int. Cl.³: H 01 L 21/31
H 01 L 21/265

(30) Priority: 18.02.83 US 468025

(43) Date of publication of application:
29.08.84 Bulletin 84/35

(84) Designated Contracting States:
DE FR GB

(71) Applicant: International Business Machines Corporati
Old Orchard Road
Armonk, N.Y. 10504(US)

(72) Inventor: Bartholomew, Robert Forbell
511 Tudor Place
Durham North Carolina 27713(US)

(72) Inventor: Campbell, David Richard, Sr.
3154 Douglas Drive
Yorktown Heights New York 10598(US)

(72) Inventor: Hansen, Howard Helge
Rd. 1, Box 95
Underhill Vermont 05489(US)

(72) Inventor: Koburger III, Charles William
Rd. 1, Box 399
Underhill Vermont 05489(US)

(72) Inventor: Wursthorn, John M.
Box 143
Underhill Center Vermont 05490(US)

(74) Representative: Klein, Daniel Jacques Henri
Compagnie IBM France Département de Propriété
Industrielle
F-06610 La Gaude(FR)

(54) Method for forming polycrystalline silicon resistors having reproducible and controllable resistivities.

(57) The ion implantation of high doses of electrically-inactive species such as carbon or nitrogen, into heavily doped polycrystalline silicon produces high resistivity material ($10^3$-$10^5$ ohms per square) having superior characteristics with respect to reproducibility and controllability as compared to lightly doped polycrystalline silicon. This material is suitable for forming resistors ideally suited for various applications in the integrated circuit field such as load devices in of high speed logic circuits where it is mandatory to control the sheet resistance precisely.

EP 0 116 702 A2

0116702

# METHOD FOR FORMING POLYCRYSTALLINE SILICON
## REPRODUCIBLE AND CONTROLLABLE RESISTIVITIES

## Description

### Field of the Invention

This invention relates to a method for forming polycrystalline silicon resistors having reproducible and controllable resistivities on a substrate and the structure produced in accordance with this method.

### Description of the Prior Art

Resistors formed by doping a shallow region into a semiconductor substrate of the opposite type of conductivity are well known in the integrated circuits field. They generally exhibit low sheet resistivity (less than about $10^3$ ohms per square), high temperature coefficient of resistance (T.C.R.) and, as a result, poor linearity.

Increased interest is being evidenced in doped polycrystalline silicon resistors formed on top of an oxide, particularly in bipolar technology where at the cost of reasonably higher processing complexity, they offer high value and, occupy little area as compared with the conventional shallow resistors formed in monocrystalline silicon.

In addition to resistors, deposited films of doped polycrystalline silicon are being used extensively in integrated circuit devices where polysilicon still acts as a conducting material. Typically polycrystalline silicon is also used for fabricating gate electrodes for Metal-Oxide semiconductor (MOS) devices, for electrical contacts, and for interconnection patterns.

Undoped thin films (a few microns or less) of polycrystalline silicon exhibit extremely high sheet resistance, at least as

high as $10^8$-$10^{10}$ ohms per square, because the conduction takes place across grain boundaries. This value is too temperature sensitive and too highly resistive.

Fabrication of relatively less resistive polycrystalline silicon films as ordinarily practiced for integrated circuit resistor applications such as for load elements for logic circuits or memory cells requires the use of lightly doped polycrystalline silicon in order to reduce the sheet resistance. Typically, a several hundred nanometer thick film is subjected to a phosphorous implantation e.g. at 100 to 150 keV to a dose of between $1 \times 10^{12}$ to $1 \times 10^{14}$ at/$cm^2$ to produce a sheet resistance in the range of $10^4$ - $10^7$ ohms per square and to create the desired characteristics of the resistors.

Following this implant step, the wafers are annealed in an N2 atmosphere for at least 30 minutes at 1000°C. The object of this step is to distribute the phosphorous atoms properly in the silicon and to activate them.

Unfortunately, lightly doped polycrystalline silicon is not an adequately reproducible material for the fabrication of resistors for integrated circuit applications. Reproducible sheet resistivities are difficult to obtain in this material since, in the lightly doped condition, the resistivity is highly sensitive to both the action of charge carrier traps at grain boundaries and to the grain size, which together have a complex and as yet unpredictable dependence on numerous processing variables (doping concentration, deposition temperature, ..). In a typical, lightly doped polysilicon film (340 nm thick, $2 \times 10^{18}$ atoms of Boron/ $cm^3$, 25 nm grain diameter), for example, increasing the grain diameter by a factor of two can result in the reduction of resistivity by a factor of $10^3$. With the same film, changing the trap density by a factor of two can result in a thousand-fold change in resistivity. This is a consequence of the critically close compensation between the concentrations of charge carriers (dopants) and grain boundary carrier traps (trapping centers), occuring in lightly doped polycrystalline silicon.

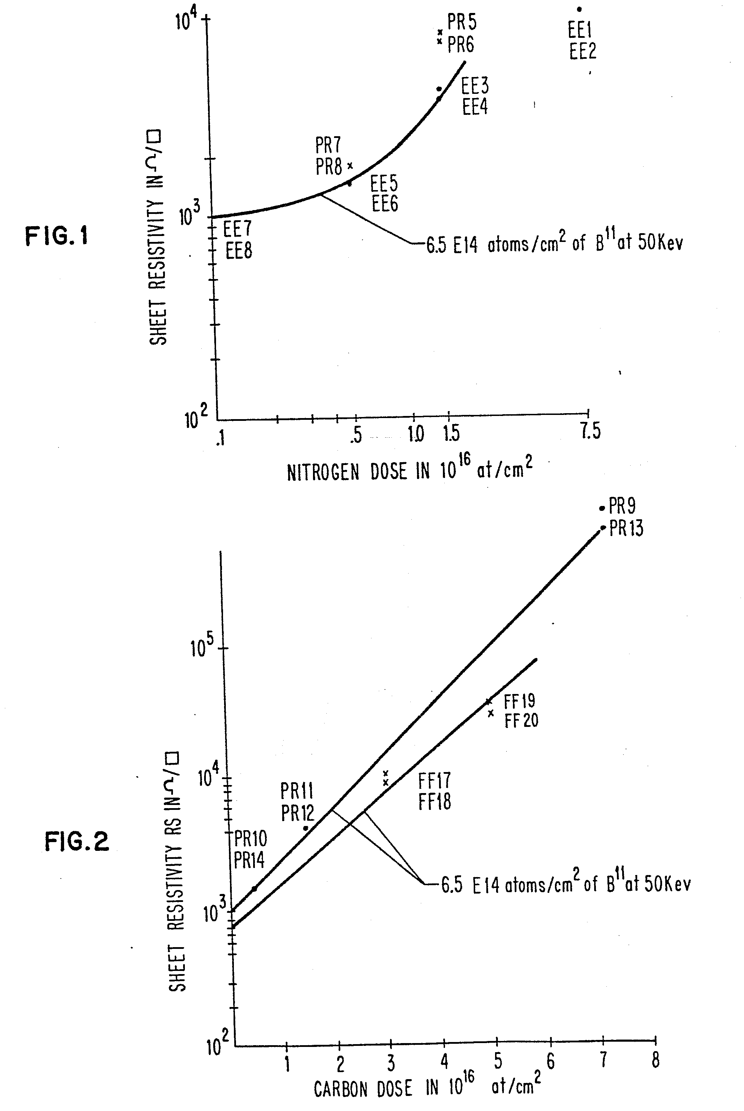

In addition, the resistivity also strongly depends on the doping level (the sheet resistance decreases more than linearly with the doping level). A good example of this can be seen in Fig. 1 in the article entitled "The Features of Resistor Load MOSIC Using Ion-Implanted Polysilicon Resistors", authored by T. Ohzone et al and published in the Transactions of the IECE of Japan Vol.E, No.4, April 1980, pages 267-274. In particular, Fig. 1 shows that a change of one order of magnitude in the doping level ($10^{14}$ to $10^{15}$ at/$cm^2$), results in a change of four orders of magnitude in the sheet resistance ($10^7$ to $10^3$ ohms per square). This article also show the strong dependency between the TCR value and the sheet resistance. Sheet resistance of lightly doped polycrystalline silicon has a stronger temperature dependence than heavily doped material.

As a direct consequence therefrom obtaining sheet resistivities in the range of $10^3$-$10^5$ ohms per square with reproducible and controllable values appears to be very difficult. Unfortunately this range is of key importance for the development of high speed logic circuits.

Shallow implanted resistors in monocrystalline silicon have been made with an additional implantation of an electrically inactive ions, such as Ar or Ne. Examples of these resistor fabrication processes include "New Technique for Improving High Value Ion Implanted Resistors" by K. H. Nicholas and R.A. Ford published in "Ion Implantation in Semiconductors" Proc. 2nd Int. Conf. on Ion Implantation in Semiconductors Springer-Verlag, Berlin, 1971, pp. 357-361; IBM TDB Vol. 22, N° 4, September 1979, pp. 1501-1502, entitled "Implanted Resistors Made With an Additional Neutral Ion Implantation by R. Chanclou et al.; and K Bulthuis et al. US-A-3,683,306. Nicholas et al. is related to neon or argon plus boron implantations in monocrystalline silicon, and it suggests that

4

01 16702

a neutral ion species could have an effect on the electrical properties of the boron doped resistors. The basic experiment examined the use of a preliminary implant of neon at 200 keV to a dose of $1 \times 10^{17}$ at/cm$^2$ to set the sheet resistance. Annealing was done between 400 and 800°C. The resistance decreases at higher annealing temperatures suggesting that the nion and/or argon form bubbles and out-diffuse from the resistor. Chanclou et al. also points out that any neutral species of neon or argon may be used, but would be expected to have a similar instability problem as shown by Nicholas et al.

Bulthuis et al. also describes a semiconductor substrate not a polycrystalline film. The patent is limited to tin and lead. Further, that patented process was designated to control TCR and not resistivity as in the present patent application.

The main objective of this invention, therefore, is to offer a controllable method of making polycrystalline silicon films having precise and reproducible resistivities with a sheet resistance on the order of $10^3 - 10^5$ ohms per square.

Another object is to provide a simple process which requires only one extra implant step with respect to standard silicon wafer processing.

## Summary of the Invention

According to the teachings of the present invention, the various inconveniences cited above can be avoided by first heavily doping the polysilicon to provide charge carriers well in excess of those necessary to fill the traps. Then, the resistivity can be increased and, unexpectedly can be accurately and reproducibly tailored by implanting with electrically inactive species particularly carbon and nitrogen atoms which do not contribute electrically. Upon subsequent heat treatments these atoms will form small and stable precipitates which will lower the mobility which, in turn, will increase resistivity.

Preferably, the resistor area is first heavily doped with an N or P type impurity in a concentration of between about 1 x $10^{19}$ to 6 x $10^{19}$ at/cm$^3$. The resistor area is then implanted with carbon or nitrogen atoms at a concentration about 3 x $10^{19}$ to 3 x $10^{21}$ at/cm$^3$.

The structure is annealed in first an oxidizing atmosphere to form a silicon dioxide cap upon the top of the polycrystalline silicon film to prevent out-diffusion of the inactive specie from the film. The heating is then continued in a non-oxidizing atmosphere, such as nitrogen, to electrically activate the dopants and heal the defects in the grains.

## Brief Description of the Drawings

Fig. 1 is a graphic representation of sheet resistivity plotted as a function of nitrogen implant dose for a heavily boron doped polycrystalline silicon film.

Fig. 2 is a graphic representation of sheet resistivity plotted as a function of carbon implant dose for two heavily boron doped polycrystalline silicon films.

Fig. 3 is a graphic representation of sheet resistivity plotted as a function of carbon implant dose for a heavily boron doped polycrystalline silicon film when a double carbon implant with two different energies is performed.

Fig. 4 is a graphic representation of sheet resistivity plotted as a function of carbon implant dose for various heavily doped phosphorous polycrystalline silicon films.

## Detailed Description of the Preferred Embodiments

Polycrystalline silicon material is composed of small crystallites joined together by grain boundaries. Inside each crystallite the atoms are arranged in a periodic manner, so that it can be considered in itself as a portion of a single crystal. The grain boundary is a complex structure, usually consisting of a few atomic layers of disordered atoms. The latter, in the grain boundary represent a transitional region between the different orientation of neighboring cristallites. There is a strong interaction between the grain boundary and the electrical properties of doped polysilicon.

Because the atoms at the grain boundary are disordered, there are a number of defects due to incomplete atomic bonding. This results in the formation of trapping states. These trapping states, acting as trapping centers, are capable of gettering carriers and thereby immobilizing them. As a consequence, the number of free carriers available for electrical conductors is reduced. When the trapping centers become charged, a potential energy barrier is created which impedes the motion of free carriers from one crystallite to the neightboring one, thereby reducing their apparent or effective mobility. This very simple explanation points out the dependence between the resistivity of the film and its doping level.

The essence of the present invention resides in the discovery that the sheet resistance of a polycrystalline silicon film deposited onto a substrate can be adjusted to a desirable value while maintaining stable, accurate and reproducible electrical caracteristics. The film is typically 50 to 1000 nanometer in thickness and preferably about 300 nanometers in thickness. It has been found that by first heavily doping the polycrystalline silicon (by an impurity of either N or P type) to provide charge carriers well in excess of those necessary to fill the trapping centers, and then ion implanting high doses of electrically inactive species such as carbon or nitrogen, one can prepare reproducible polycrystalline silicon resistors with relatively high sheet resistance (in the range of $10^3$-$10^5$ ohms per square) ideally suited for many integrated circuit applications.

In the first step, the polycrystalline silicon must be doped heavily enough so that the traps can be filled using only a small fraction of the carriers provided by the doping. The influence of the grain boundary traps will then be made relatively weak.

Carrier trapping will create only a small decrease in overall free carrier concentration, and the band bending at the interface between adjoining grains will be minimal. The small energy barrier will not therefore significantly impede the flow of majority carriers from the interior of one grain to the next grain.

With, for example, boron and phosphorous as dopants, it is necessary to implant from 30 to 200 times the amount necessary to sature the carrier traps. In others words, 30 to 200 times the ratio of the grain boundary trapping state density $N_t$ : $Q_t/cm^2$ to the grain size L (in cm). This heavily doped impurity is typically between about $1 \times 10^{19}$ to $6 \times 10^{19}$ at/$cm^3$. Particularly for phosphorus the concentration is preferred to be between about $1.6 \times 10^{19}$ to $6 \times 10^{19}$ at/$cm^3$. Polycrystalline silicon films which are then obtained exhibit a sheet resistivity of about $10^3$ ohms per square or even slightly less.

The purpose of the second doping in the next step is to intentionally introduce a finely dispersed and high density of defect centers which will increase scattering events and trap carriers. This will increase resistivity by lowering the mobility and density of charge carriers. Defect centers may be introduced by implanting high doses of chemically reactive, electrically neutral species such as nitrogen and carbon. Upon high temperature annealing, finely dispersed and stable precipitates will form which are effective hole or electrons scatterers. For nitrogen and carbon the doping range is from 3 x $10^{19}$ to 3 x $10^{21}$ at/$cm^3$.

The annealing step preferably involves an initial short thermal oxidation step followed by annealing in a non-oxidizing atmosphere. It is preferred to accomplish these steps at a temperature of less than about 1000°C. The oxidation step produces a thin silicon dioxide cap in the order of tens of nanometers on the surface to prevent out-diffusion of the inactive specie. The non-oxidizing atmosphere annealing accomplishes activation of the dopant and healing of defects.

In the final stage of the process, the sheet resistivity of polysilicon films can be tailored to any desired value between $10^3$ and $10^5$ ohms per square.

The effectiveness of this concept is demonstrated in Figs. 1 to 4 and related tables I to IV which exhibit a distinct relationship between film resistivity and implant dose. It has been found through the following Examples that a log-linear relationship holds for a variety of processing variations. These Examples further illustrate various features of the invention but are intended in no way to limit the scope of the invention as defined by the appended claims.

Example 1 : Nitrogen implant into boron doped polycrystalline silicon.

Approximately 300 nm of polycrystalline silicon was deposited onto 104 nm of thermal silicon dioxide, on ten sample wafers referenced as EE1 to EE10. For all ten wafers, the polycrystalline silicon was then implanted with boron ions at a dose of 6.5 x $10^{14}$ at/$cm^2$ at 50 keV which should give an $R_s$ value in the 800 to 1000 ohms per square range (see samples referenced EE.9 and 10). For eight other wafers referenced EE1 to EE8, there was desired a maximum of 5 atomic percent of nitrogen. Since the density of silicon is

$5.0 \times 10^{22}$ at/cm$^3$, the concentration of nitrogen atoms to be implanted is then $2.5 \times 10^{21}$ at/cm$^3$ which corresponds to a maximum dose of $7.5 \times 10^{16}$ at/cm$^2$. The implant energy for nitrogen was 180 keV. The wafers were annealed at 1000°C using a 2 minutes $O_2$/28 minutes $N_2$ cycle. The $O_2$ portion of the cycle produced a silicon dioxide cap upon the surface of the polycrystalline silicon film. Sheet resistance was measured according to the 4-point method, on three different points to provide an average value of $R_s$.

The correspondence between the implanted dose and the resulting sheet resistance $R_s$ for the sample wafers referenced EE1 to EE10 is shown in Table I.

TABLE I

| | B$^{11}$ IM-PLANT 50 keV | N$^{14}$ IM-PLANT 180 keV | |
|---|---|---|---|
| Ref. of wafer | IMPLANT DOSE (at/cm$^2$) | IMPLANT DOSE (at/cm$^2$) | SHEET RESIST. RS (ohms per square) |
| EE1 | 6.5 E14 | 7.5 E16 | 10300 |
| EE2 | — | — | 9900 |
| EE3 | — | 1.5 E16 | 4100 |
| EE4 | — | — | 3950 |
| EE5 | — | 5.0 E15 | 1460 |
| EE6 | — | — | 1470 |
| EE7 | — | 1.0 E15 | 1010 |
| EE8 | — | — | 1000 |
| EE9 | — | no impl. | 943 |
| E10 | — | — | 946 |

Fig. 1 illustrates data on the first set of samples (EE1-8) implanted with nitrogen. Curve I clearly shows the enhancement of sheet resistivity in polysilicon when implanted with nitrogen. Beyond a few atomic percent of $N_2$, this effect

0116702

becomes quite pronounced producing nearly an order of magnitude increase of the sheet resistance compared with samples not submitted to the nitrogen implantation (wafers EE9-EE10).

Example 2 : Nitrogen and carbon implants into boron-doped polycrystalline silicon.

Fourteen wafers referenced PR 1 to 14 were prepared with 320 nm of polycrystalline silicon deposited on top of a 95 nm thermal oxide layer. All wafers received an implantation of boron at a dose of $6.5 \ 10^{14}/cm^2$ with an energy of 50 keV. Wafers PR 1 and 2 served as test wafers and were doped with boron only. Carbon and nitrogen were implanted in wafers PR 3 to 14 with various doses. After implantation, the wafers were annealed at 1000°C using a 2 minute $O_2$/28 minute $N_2$ cycle in order to grow a thin capping silicon dioxide at the start of the anneal. Sheet resistance was measured on the 4-point probe at the same 3 positions as mentionned above.

Tables IIA and IIB respectively give the sheet resistivity measurements for this set of wafers (PR1 to PR14) as a function of the dopant used to produce scattering centers : Nitrogen or Carbon.

## TABLE IIA

| Ref. of wafer | $B^{11}$ IM-PLANT 50 keV IMPLANT DOSE $(at/cm^2)$ | $N^{14}$ IM-PLANT 180 keV IMPLANT DOSE $(at/cm^2)$ | SHEET RESIST. RS (ohms per square) |
|---|---|---|---|
| PR1 | 6.5  E14 | no impl. | 935 |
| PR2 | – | – | 894 |
| PR3 | – | 7.5 E16 | 4.35 E5 |
| PR4 | – | – | 4.73 E4 |
| PR5 | – | 1.5 E16 | 7.56 E3 |
| PR6 | – | – | 7.57 E3 |
| PR7 | – | 5.0 E15 | 1.78 E3 |
| PR8 | – | – | 1.78 E3 |

## TABLE IIB

| Ref. of wafer | $B^{11}$ IM-PLANT 50 keV IMPLANT DOSE $(at/cm^2)$ | $C^{12}$ IM-PLANT 75 keV IMPLANT DOSE $(at/cm^2)$ | SHEET RESIST. RS (ohms per square) |
|---|---|---|---|
| PR9 | 6.5. E14 | 7.5. E16 | 8.69 E5 |
| PR13 | – | – | 5.83 E5 |
| PR11 | – | 1.5 E16 | 4.1  E3 |
| PR12 | – | – | 4.03 E3 |
| PR10 | – | 5.0 E15 | 1.60 E3 |
| PR14 | – | – | 1.65 E3 |

Example 3 : Single and multiple carbon implants into boron doped polycrystalline silicon.

0116702

Sample wafers FF1 to FF20 were first thermally oxidized (thickness of the $SiO_2$ layer: 114 nm), then 290 nm polycrystalline silicon were deposited onto the silicon dioxide layer, and finally boron was implanted at a dose of $6.5 \times 10^{14}$ and an energy of 50 keV.

The first set of wafers (FF1, 2, 5, 6, 9, 10, 13, 14, 17, 18, 19, 20) was annealed at 1000°C for 30 minutes prior to the carbon implant.

All of the wafers referenced FF1-16 were given a double carbon implant at two different energies (40 and 90 keV) for various carbon implant doses.

The remaining wafers, referenced FF17-20 were given only a single carbon implant with an energy of 75 keV for different carbon implant doses. All wafers were then annealed as mentionned above, the first set of wafers being annealed twice.

The sheet resistance was measured using the same conditions as mentioned above.

Sheet resistivity measured after the prior anneal (1000°C) with the first set of wafers, has been found to be in the range of 700 to 746 ohms per square with an average value of about 725 ohms per square.

Tables IIIA and IIIB give the respective sheet resistivity measurements for both groups of wafers.

## TABLE IIIA

| Ref. of wafer | FIRST C IMPLANT at 40 keV | SECOND C IMPLANT at 90 keV | |
|---|---|---|---|
| | IMPLANT DOSE $(at/cm^2)$ | IMPLANT DOSE $(at/cm^2)$ | SHEET RESIST. RS (ohms per square) |
| FF1* | 1.0 E16 | 1.0 E16 | 1.60 E3 |
| FF2* | – | – | 1.64 E3 |
| FF3 | – | – | 2.56 E3 |
| FF4 | – | – | 2.45 E3 |
| FF5* | 3.0 E16 | 3.0 E16 | 2.09 E4 |
| FF6* | – | – | 1.97 E4 |
| FF7 | – | – | 2.14 E4 |
| FF8 | – | – | 2.09 E4 |
| FF9* | 5.0. E16 | 5.0. E16 | 2.96 E5 |
| FF10* | – | – | 1.64 E5 |
| FF11 | – | – | 1.88 E5 |
| FF12 | – | – | 3.03 E5 |
| FF13* | 7.0 E16 | 7.0 E16 | 4.90 E6 |
| FF14* | – | – | 3.87 E6 |
| FF15 | – | – | 2.56 E6 |
| FF16 | – | – | 2.18 E6 |

TABLE IIIB

| Ref. of wafer | C12 IMPLANT DOSE (75 keV) IMPLANT DOSE $(at/cm^2)$ | SHEET RESIST. RS (ohms per square) |
|---|---|---|
| FF17* | 3.0 E16 | 9.49 E3 |
| FF18* | – | 9.40 E3 |
| FF19* | 5.0 E16 | 3.66 E4 |
| FF20* | – | 2.94 E4 |

\*    Wafers marked with an asterisk constitute said first set of wafers, which were annealed before implantation took place.

Fig. 2 illustrates a plot of log $R_s$ (ohms per square) vs Carbon dose (in $at/cm^2$) for boron-doped samples, prepared at different times corresponding to Tables IIB and IIIB. The parallel slopes for the two data sets indicate that the same mechanism prevails in both cases. The offset in the two data sets is due to an apparent variation in the initial boron implant dose and is not due to the carbon implant and/or subsequent processing. The resistivities of wafers before the carbon implantation were probably not the same because they came from different lots.

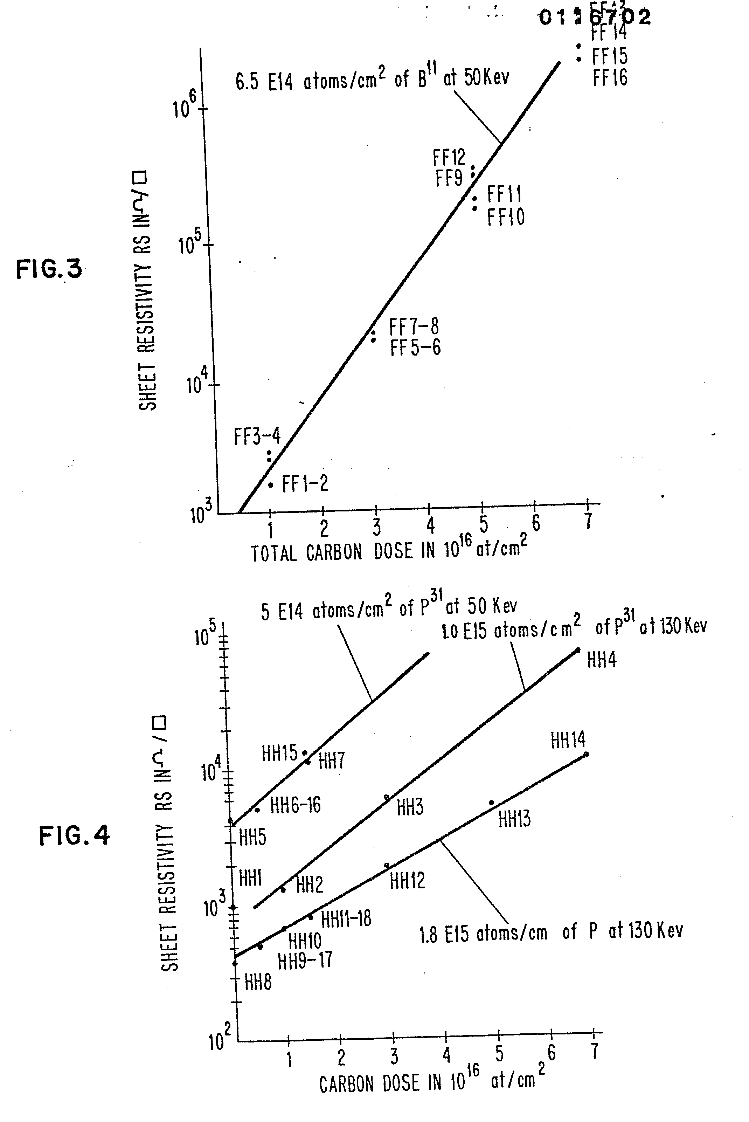

Fig. 3 illustrates a plot of log $R_s$ (ohms per square) Vs carbon dose (in $at/cm^2$) for boron doped polycrystalline silicon samples subjected to a double carbon implant with two different energies as indicated in Table IIA. Two different implant energies were utilized in order to spread the distribution of implanted carbon more evenly throughout the thickness of the film. This makes the implant process more
effective in increasing $R_s$ as evidenced by the steeper slope
in this figure as compared to Fig. 2. Also, there is no
discernable difference in the samples (FF1, 2, 5, 6, 9, 10,
13, 14) annealed twice, i.e., once after the boron implantation and once after the carbon implantation, as compared
to samples annealed only once (FF3, 4, 7, 8, 11, 12, 15, 16).

Example 4 : Carbon implant into phosphorous doped
polycrystalline silicon.

Wafers having 400 nm films of intrinsic low pressure chemical
vapor deposited, LPCVD, polycrystalline silicon were prepared.
A first set of wafers, referenced HH1 to HH15 was then
implanted with phosphorous and carbon using the doses and
energies depicted in Table IVA. Following this procedure, the
samples were annealed/oxidized at 1000°C, employing a 5 minute
$O_2$ / 30 minute $N_2$ cycle. The 5 minutes oxidation was used
to form a silicon dioxide cap on the polycrystalline silicon
surface. A second set of wafers was added to the lot prior to
this step in order to determine the susceptibility of the
resistivity to changes in the heat cycle. These wafers are
those numbered HH16 to HH19 in Table IVA. These wafers during
previous processing had already received an identical heat
cycle. All wafers then were dipped in buffered HF to remove
the oxide, and had their resistivity measured employing an
in-line four-point probe, and monitored using the standard
process characterization system.

The resulting sheet resistivities, for both sets of samples,
including those wafers (HH16 to 19) receiving the double
anneal, are summarized in Table IVA which follows.

## TABLE IVA

| Ref. of wafer | $P^{31}$ IMPLANT (130 keV) IMPLANT DOSE (at/cm$^2$) | $C^{12}$ IMPLANT (75 keV) IMPLANT DOSE (at/cm$^2$) | SHEET RESIST. RS (ohms per square) |
|---|---|---|---|
| HH1 | 1.0 E15 | 1.0 E15 | 1200 |
| HH2 | — | 5.0 E15 | 1200 |
| HH3 | — | 1.0 E16 | 1450 |
| HH4 | — | 3.0 E16 | 6200 |
| HH5 | — | 7.0 E16 | 82000 |
| HH6 | 5.0 E14 | 1.0 E15 | 4100 |
| HH7 | — | 5.0 E15 | 4200 |
| HH8 | — | 1.5 E15 | 10000 |
| HH9 | 1.8 E15 | 1.0 E15 | 400 |
| HH10 | — | 5.0 E15 | 500 |
| HH11 | — | 1.0 E16 | 680 |
| HH12 | — | 1.5 E16 | 817 |
| HH13 | — | 3.0 E16 | 1860 |
| HH14 | — | 5.0 E16 | 5260 |
| HH15 | — | 7.0 E16 | 11200 |
| HH16 | 5.0 E15 | 1.5 E16 | 12000 |
| HH17 | — | 0.5 E16 | 5400 |
| HH18 | 1.8 E15 | 0.5 E16 | 484 |
| HH19 | — | 1.5 E16 | 785 |

The remaining wafers referenced HH19 to HH22, were submitted to a double carbon implantation, in order to measure the influence of such a second step Sheet resistivities are given in Table IVB.

TABLE IVB

| | $P^{31}$ IMPLANT (130 keV) | $C^{12}$ IMPLANT (75 keV) | |
|---|---|---|---|
| Ref. of wafer | IMPLANT DOSE (at/cm$^2$) | IMPLANT DOSE (at/cm$^2$) | SHEET RESIST. RS (ohms per square) |
| HH20 | 0.75 E16 | 0.75 E16 | 840 |
| HH21 | 1.0 E16 | 1.6 E16 | 430 |
| HH22 | 3.75 E16 | 3.75 E16 | highly resistive |
| HH23 | 4.8 E16 | 7.8 E16 | highly resistive |

Multiple implants (wafers HH19 and 22) proved more difficult to characterize. Designed to indicate the separate effects of dose vs. peak concentration, the wafers' data appear to offer little information. Wafers HH21-22 had resistivities too high to measure. The data for wafer HH19 might suggest more dependence on overall dose than on peak concentrations. HH19, having the same total carbon dose as samples HH11 and HH18, has a resistivity (840 ohms per square) similar to those of the single-implanted wafers HH11 (817 ohms per square) or HH18 (785 ohms per square). Wafer HH20, however, with a much higher total dose, has a lower resistivity. The reason for this was not apparent.

Fig. 4 illustrates a plot of log $R_s$ (ohms per square) vs carbon dose (in at/cm$^2$) for three different phosphorus doses and for a range of carbon doses varying by approximately one order of magnitude according to the Figures given in Table IVA. Fig. 4 shows excellent reproducibility when using carbon to control $R_s$. The upward displacement of the lines follows the expected trend for decreasing P doses. The lines are roughly parallel, given the limited data. This suggests that the carbon-implant method for tailoring the $R_s$ values works regardless of doping concentration and doping type, i.e., N or P.

Good control, as measured by the sensitivity of resistance to small changes in dose (small sensitivity meaning better control), was also very good up to resistivities of approximately 1 to 2 x $10^4$ ohms per square, depending on phosphorous dose. Doubling of the anneal cycle is found to produce very minimal change in resistivity indicating the thermal stability of the material (wafers HH15 to 18).

The above data verify the effectiveness and process in variance of the nitrogen or carbon implant method for forming thin film resistors. In addition, the existence of a log-linear relationship between $R_s$ and the concentration of ion implanted carbon (or nitrogen) indicates a high degree of predictability which is very important commercially inasmuch as this is a key asset for the design and processing of integrated circuit resistors.

It has been demonstrated that the above method assures repeatability and controllability by using implanted carbon or nitrogen atoms to increase the resistivity of doped polycrystalline silicon films. This probably results from the ability of these species to control the grain growth in the films. Unexpectedly controlling the grain growth did not result in producing lower stresses (and thereby decreasing the pinhole density) in addition to the remarkably good resistivity control.

While the invention has been particularly shown and described with reference to preferred embodiments thereof, it will be understood by those skilled in the art that the foregoing and other changes in form and details may be made without departing from the spirit and scope of the invention.

## CLAIMS

1. A method of forming high resistivity polycrystalline silicon film disposed on a substrate comprising the steps of :

    a) heavily doping the polycrystalline silicon film with an impurity either of P or N type, in an amount well in excess of the trapping density of said film to saturate them,

    b) ion implanting the polycrystalline silicon film with an electrically inactive specie taken from the group consisting of carbon and nitrogen, in order to enhance the sheet resistivity, and

    c) annealing the polycrystalline silicon film in order to activate electrically the dopants and to heal the defects in the grains.

2. A method as recited in claim 1 wherein said electrically inactive species is implanted with a concentration in the $3.10^{19}$ to $3.10^{21}$ at/cm$^3$ range.

3. A method as recited in claim 1 or 2 wherein said impurity is boron which is implanted with a dose of about $6.4$ $10^{14}$ at/cm$^2$, at about 50 keV.

4. A method as recited in claim 3 wherein said inactive species is nitrogen which is implanted at 180 keV.

5. A method as recited in claim 3 wherein said inactive species is carbon which is implanted at 75 kev.

6. A method as recited in claim 3 wherein said inactive species is carbon which is implanted at 40 keV at 90 keV in two successive steps.

7.	A method as recited in claim 1 or 2 wherein said impurity is phosphorous which is implanted with a dose in the $5.10^{14} - 1.8 \ 10^{15}$ at/cm$^2$ range, at about 130 keV.

8.	A method as recited in claim 7 wherein said inactive specie is carbon which is implanted at 75 keV.

9.	A method as recited in any of above claims wherein said film is annealed in a 2 minute $O_2$/28 minute $N_2$ cycle.

10.	A method as recited in any of above claims wherein said substrate comprises a silicon wafer having a layer of silicon dioxide disposed thereon, said polycrystalline silicon film being deposited on the silicon dioxide layer.

11.	A structure produced in accordance with the method of any of above claims.

12.	A structure as recited in claim 11 wherein a protective coating such as thermal oxide is provided over the polycrystalline silicon film.

FIG.1

SHEET RESISTIVITY IN Ω/□

6.5 E14 atoms/cm² of B¹¹ at 50 Kev

NITROGEN DOSE IN $10^{16}$ at/cm²

FIG.2

SHEET RESISTIVITY RS IN Ω/□

6.5 E14 atoms/cm² of B¹¹ at 50 Kev

CARBON DOSE IN $10^{16}$ at/cm²

0116702

1/2

FIG.3

FIG.4